# EUROPEAN PATENT SPECIFICATION

(11) **EP 0 392 582 B1**
(45) Date of publication and mention of the grant of the patent: **26.07.1995**
(21) Application number: 90200734.3
(22) Date of filing: 28.03.1990
(51) Int. Cl.: G01R 23/15

(54) **Method of frequency discrimination**
Verfahren zum Differenzieren von Frequenzen
Procédé de différenciation de fréquences

(30) Priority: 03.04.1989 NL 8900807
(43) Date of publication of application: 17.10.1990
(73) Proprietor: Philips Electronics N.V., 5621 BA Eindhoven (NL)
(72) Inventor: Rhebergen, Gertjan, NL-5656 AA Eindhoven (NL)
(74) Representative: De Jongh, Cornelis Dominicus

(56) References cited:
- EP-A- 0 058 050
- US-A- 4 231 029
- PATENT ABSTRACTS OF JAPAN, vol. 7, no. 130 (P-202), 7th June 1983;& JP-A-56 145 261 (TOKYO SHIBAURA DENKI K.K.) 18-03-1983

## Description

The invention relates to a method of frequency discrimination of an a.c. voltage by means of a processor linked to the a.c. voltage, in which:
- a first zero-crossing of the a.c. voltage is detected in response to which a program in the processor is initiated;
- this program comprises a loop with a fixed number of instructions, the cycle time of the loop being much smaller than a minimum foreseeable period of the a.c. voltage and
- this loop comprises a counting instruction for counting the number of passed loop cycles.

The invention likewise related to a device suitable for implementing this method.

Such a method is known from Japanese Patent Application No. 56-145261 laid open to public inspection. In this Japanese Patent Application two possible frequencies of an a.c. voltage are discriminated by generating, after a zero-crossing of the a.c. voltage, a signal that has a duration comprised between the periods belonging to the two possible frequencies. At the terminal instant of this signal the polarity of the a.c. voltage is perceived, which polarity forms an indication for the frequency to be determined. If the polarity is then equal to the one immediately after the detected zero-crossing, the period is shorter than the duration of the signal. With opposite polarities the period is longer than the duration of the signal. In the former case the frequency is the higher of the two and in the latter case the lower of the two.

Thus, in this context it is only possible to discriminate between two optional frequencies, because the polarity either remains the same or changes signs.

In the European Patent Application No. A-0058050 a device for frequency detection is disclosed. This device detects the zerocrossing of an AC input voltage. In response thereto clock pulses, having a known repetition interval and generated by a clock pulse generator circuit, are counted by a separate counter, until a second zerocrossing of the AC voltage is detected. The value of the counter is then compared by a separate comparator with a value representing a predetermined frequency. In consequence of this comparation it is decided whether the frequency of the input voltage is smaller or larger than the predetermined frequency.

The US-patent No. 4,231,029 describes a device for generating an alarm signal when the frequency of an AC input voltage is outside a predetermined range. These device differs from the device described hereabove in that the zero crossing detector activates a clock pulse generator after a first zero cross and deactivates the clock pulse generator after a second zero cross. During a first halfperiod the circuit tests if the incoming signal is above a low frequency limit and during a succeeding halfperiod the circuit tests if the incoming signal is below a high frequency limit. The way of counting the clock pulses and comparing the final value of the counter with a value representing a predetermined frequency are carried out the same as in the frequency detection device.

Both these devices comprise separate counters, comparators and clock pulse generators. This means that apparatuses comprising such devices are supplied with an extra counter, an extra comparator and an extra clock pulse generator. When the device of US 4,231,029 is to discriminate among more than two frequencies, the method should be repeated during additional half periods, whereby in each half period the number of clock pulses is to be compared with a different predetermined value.

It is an object of the invention to enable discrimation among various frequencies completely on the basis of software during one half period of the a.c. voltage.

For this purpose, the method according to the invention is characterized in that
- this loop comprises a detecting instruction for detecting a next zero-crossing;
- in response to the detection of this next zero-crossing the loop is abandoned;
- subsequently, the number of passed loop cycles is compared to at least a first preset value and
- depending on the result of the comparison at least a first output conductor of the processor is moved to a corresponding logic state.

After a first zero-crossing is detected the program counts the number of loop cycles passed through, whose cycle times are known, until a next zero-crossing is detected. This total number of loop cycles passed through is decisive for the time interval between the two zero-crossings and thus also for the period of the a.c. voltage. Then, the total number of loop cycles passed through is compared with one or more preset values. When a comparison is made with one preset value, the total number of loop cycles passed through is smaller or larger than this value and thus a distinction can be made between two possible frequencies. In this case a single output conductor will suffice for displaying the result of the comparison (for example, the logic value "one" for the highest frequency and the logic value "zero" for the lowest frequency).

An embodiment of the method according to the invention is characterized in that,
- in dependence on the comparison with the first output conductor the number of passed loop cycles is compared with at least a second preset value, and
- at least a second output conductor of the processor is moved to a corresponding logic state.

When comparing with tow or three preset values respectively, a distinction can be made between three or four possible frequencies respectively, In this case two output conductors will suffice for displaying the result of the comparison (for example, if a distinction is made between four possible frequencies, the values "zero" (00), "one" (01), "two" (10) and "three" (11) can be chosen for the respective possible frequencies).

The method according to the invention does not need extra clock pulse generators, counters or comparators as in the prior art. The functions of these components are taken care of by the processor, which in most modern apparatuses, like for example a modern telephone, is present already. Furthermore discrimination can be made among a high number of frequencies without repetition of the method during additional half periods. A way to achieve this goal will be worked out in the detailed description. It is also easy to adjust a device, working according the invention, to another frequency range. This can be done by modifying the length of a loop cycle by increasing or decreasing the number of instructions used therein.

The invention will now be further explained with the aid of embodiments represented in the drawing Figures, in which:
Fig. 1 shows a flow chart of the method according to the invention of discriminating between two possible frequencies;
Fig. 2 shows another flow chart of the method according to the invention of discriminating among four possible frequencies;
Fig. 3 shows a block diagram of a device suitable for implementing the method according to the invention.

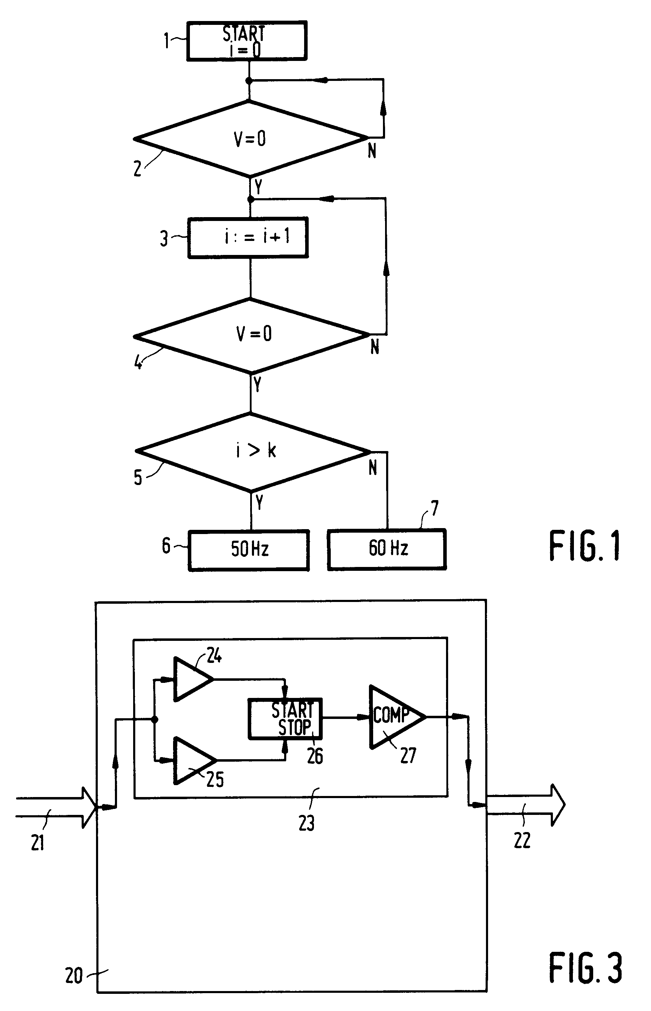

The flow chart represented in Fig. 1 comprises 7 blocks, having the following descriptions:
- block 1 (start; i=0); when the method is started the number of passed read cycles i is set to zero;
- block 2 (test zero-crossing, V=0?); as long as no zero-crossing of the a.c. voltage is detected, the method continues testing for this; if a zero-crossing is detected indeed: proceed to block 3;
- block 3 (i:=i+1); the number of passed loop cycles i is incremented by one;
- block 4 (test zero-crossing, V=0?); as long as no zero-crossing is detected: return to block 3; blocks 3 and 4 together form a read cycle; if a zero-crossing is detected indeed: proceed to block 5;
- block 5 (test i>k?); i is the number of passed loop cycles; k is the preset value; if i>k: proceed to block 6, otherwise proceed to block 7;
- block 6 (50 Hz); the frequency of the a.c. voltage is 50 Hz;
- block 7 (60 Hz); the frequency of the a.c. voltage is 60 Hz.

If a device comprising a processor such as, for example, a telephone set, is connected to the electric mains, whose frequency is 50 or 60 Hz, the program whose flow chart is represented in Fig. 1 is initiated. The number of passed loop cycles, indicated by the letter i, receives the value zero (block 1). Then, the program tests whether a zero-crossing occurs in the a.c. voltage of the electric mains (block 2). As long as this does not happen, the program continues testing. The hardware link between the processor and the electric mains required for detecting a zero-crossing will generally already be available, for example, if the telephone set displays the time of day on an alphanumeric display. The a.c. voltage of the electric mains provides a better long-term stability than the relatively inaccurate processor clock.

If the hardware link between the processor and the electric mains is not available, this link can be realised simply and inexpensively in a manner known to those skilled in the art.

If the program detects a zero-crossing in the a.c. voltage of the electric mains (block 2), the program will enter a loop (blocks 3 and 4). This loop comprises a fixed amount of instructions and consequently has a constant cycle time of, for example, 10 »secs. In this loop the number of passed loop cycles i is first incremented by one (block 3) and then tested for a zero-crossing of the a.c. voltage (block 4). As long as this zero-crossing is not detected the program remains in the loop (proceed to block 3). If the zero-crossing is detected indeed, the program will leave the loop and test whether the number of passed loop cycles i exceeds a preset value k (block 5). If it does, the program will select a frequency of 50 Hz (block 6). If the number of passed loop cycles i does not exceed the preset value k, the program will choose in favour of a frequency of 60 Hz (block 7).

With a frequency of 50 Hz the interval between two consecutive zero-crossings (a half period) is 10 msecs. With a frequency of 60 Hz this is approximately 8.33 msecs. In the former case the number of passed loop cycles will be approximately 1000, in the second case approximately 833. A value situated between 833 and 1000, for example, the value 900, is then to be chosen for k.

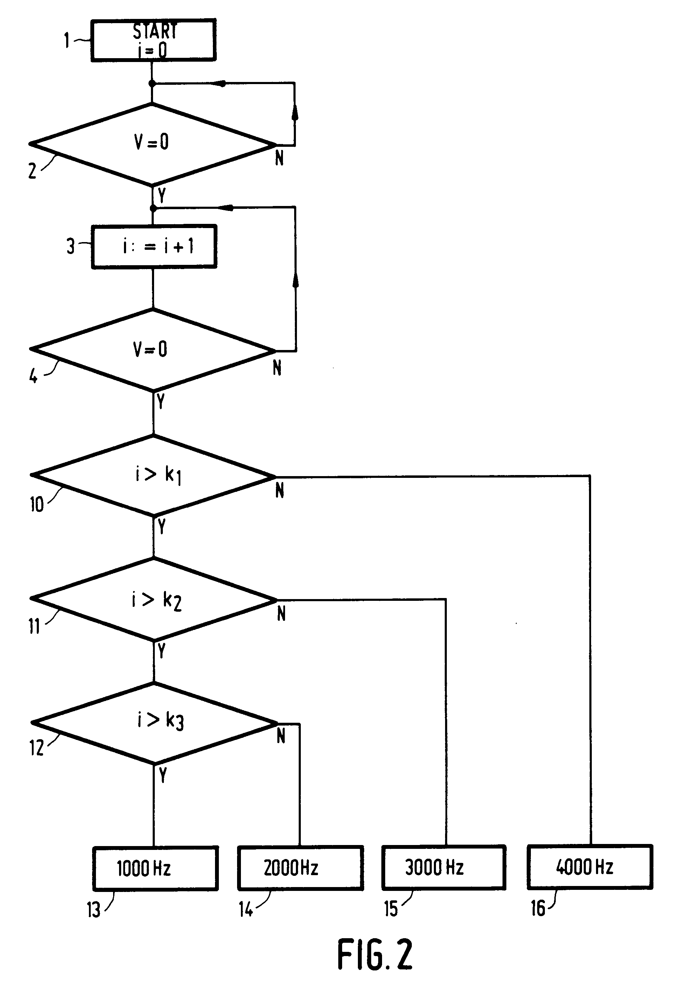

The flow chart represented in Fig. 2 comprises 11 blocks having the following descriptions:
- block 1 (start; i=0); see Fig. 1;
- block 2 (test zero-crossing, V=0?); see Fig. 1;
- block 3 (i:=i+1); see Fig. 1;
- block 4 (test zero-crossing, V=0?); see Fig. 1;
- block 10 (test i>k₁?); k₁ is the first preset value; if i>k₁, proceed to block 11, otherwise proceed to block 16;
- block 11 (test i>k₂?); k₂ is the second preset value (k₂>k₁); if i>k₂ proceed to block 12, otherwise proceed to block 15;
- block 12 (test i>k₃?); k₃ is the third preset value (k₃>k₂); if i>k₃, proceed to block 13, otherwise proceed to block 14;
- block 13 (1000 Hz); the frequency of the a.c. voltage is 1000 Hz;
- block 14 (2000 Hz); the frequency of the a.c. voltage is 2000 Hz;
- block 15 (3000 Hz); the frequency of the a.c. voltage is 3000 Hz;
- block 16 (4000 Hz); the frequency of the a.c. voltage is 4000 Hz.

A program operating along the lines of this flow chart discriminates among four possible frequencies which are 1000, 2000, 3000 and 4000 Hz in this exemplary embodiment.

When the program is initiated the number of passed loop cycles i is assigned the value zero. Subsequently, the program tests whether there is a zero-crossing of the a.c. voltage (block 2). As long as this is not the case, the program continues testing for this. Concerning the hardware link between the processor and the a.c. voltage it holds, as already described with respect to Fig. 1, that if this link is not available, it can be realised simply and inexpensively in a manner known to those skilled in the art.

If the program detects a zero-crossing of the a.c. voltage (block 2), the program will enter a loop (blocks 3 and 4) with a fixed number of instructions. Consequently, the cycle time is constant, again 10»secs, for example, as was also assumed in the description of Fig. 1. By increasing or decreasing respectively, the number of instructions in the loop the cycle time becomes longer or shorter respectively, and can be brought to a desired value depending on the size(s) of the frequency(ies) to be determined.

In this loop first the number of passed read cycles i is incremented by one (block 3) and then it is tested whether there is a zero-crossing of the a.c. voltage (block 4). If the zero-crossing is detected the program will abandon the loop and test whether the number of passed loop cycles i exceeds a first preset value k₁ (block 10). If it does not exceed this value, the program will choose in favour of a frequency of 4000 Hz (block 16). If it does exceed this value the program will test whether the number of passed loop cycles i exceeds a second preset value k₂ (block 11). If it does not exceed this value, the program will choose in favour of a frequency of 3000 Hz (block 15). If it does exceed this value, the program will test whether the number of passed loop cycles i exceeds a third preset value k₃ (block 12). If it does not exceed this value, the program will choose in favour of a frequency of 2000 Hz and if it does, the program will choose in favour of a frequency of 1000 Hz.

At a frequency of 1000 Hz the interval between two consecutive zero-crossings (a half period) is 500 »secs, which corresponds with approximately 50 loop cycles. Similarly, for a frequency of 2000 Hz an interval is found of 250 »secs (approximately 25 loop cycles). A frequency of 3000 Hz has an interval of approximately 167 »secs (approximately 16 loop cycles) and a frequency of 4000 Hz has an interval of 125 »secs (approximately 12 loop cycles). The first preset value k₁ is then to be chosen between the values 12 and 16, for example the value 14. The second preset value k₂ is then to be chosen between the values 16 and 25, for example, the value 20. The third preset value k₃ is then to be chosen between the values 25 and 50, for example, the value 37.

Fig. 3 shows a block diagram of an arrangement suitable for implementing the method according to the invention and comprising a processor 20 having an input conductor 21 and an output conductor 22, which are both coupled to the memory fields 23 inside the processor 20. In these memory fields 23 a first zero-crossing detector function 24, a second zero-crossing detector function 25, a counter function 26 and a comparator function 27 are realised by means of software. After a first zero-crossing is detected by the first zero-crossing detector function 24 the program with the loop with the fixed number of instructions is initiated as is the counter function 26, counting the number of passed loop cycles. After a next zero-crossing is detected by the second zero-crossing detector function 25, this counter function 26 is stopped. The comparator function 27 then compares the count of the counter function 26, this count being equal to the number of passed loop cycles, with one or a plurality of preset values and, in response thereto, applies an output signal to output conductor 22 which is consequently moved to a logic state belonging to the result of the comparison.

## Claims

1. A method of frequency discrimination of an a.c. voltage by means of a processor linked to the a.c. voltage, in which:
- a first zero-crossing of the a.c. voltage is detected in response to which a program in the processor is initiated;
- this program comprises a loop with a fixed number of instructions, the cycle time of this loop being much smaller than a minimum foreseeable period of the a.c. voltage and
- this loop comprises a counting instruction for counting the number of passed loop cycles,
characterized in that
- this loop comprises a detecting instruction for detecting a next zero-crossing;
- in response to the detection of this next zero-crossing the loop is abandoned;
- subsequently, the number of passed loop cycles is compared to at least a first preset value and
- depending on the result of the comparison at least a first output conductor of the processor is moved to a corresponding logic state.

2. A method of frequency discrimination of an a.c. voltage according to claim 1, characterized in that,
- in dependence on the comparison with the first output conductor the number of passed loop cycles is compared with at least a second preset value, and
- at least a second output conductor of the processor is moved to a corresponding logic state.

3. A device suitable for implementing the method as claimed in claim 1, comprising the processor which is linked to the a.c. voltage and arranged for performing the following steps;
- detecting the zero-crossing of the a.c. voltage in response to which in the processor the program comprising the loop with a fixed number of instructions is started of which loop the cycle time is much shorter than the minimum foreseeable period of the a.c. voltage and
- adding the number of passed loop cycles,
characterized in that the processor is further arranged for performing the following steps;
- detecting the next zero-crossing during each loop cycle;
- abandoning the loop after detection of this next zero-crossing,
- comparing the number of passed loop cycles with at least a first preset value and
- depending on the result of the comparison, moving at least a first output conductor to the corresponding logic state.

## Patentansprüche

1. Verfahren zum Differenzieren von Frequenzen einer Wechselspannung mittels eines mit der Wechselspannung verbundenen Prozessors, wobei:
- ein erster Nulldurchgang der Wechselspannung detektiert wird, worauf in dem Prozessor ein Programm gestartet wird;
- dieses Programm eine Schleife umfaßt mit einer festen Anzahl von Instruktionen, wobei die Zykluszeit dieser Schleife viel kleiner ist als eine minimal zu erwartende Periode der Wechselspannung, und
- die Schleife eine Zählinstruktion umfaßt zum Zählen der Anzahl durchlaufener Schleifenzyklen,
dadurch gekennzeichnet, daß
- diese Schleife eine Detektionsinstruktion umfaßt zum Detektieren eines nächten Nulldurchgangs
- in Antwort auf die Detektion dieses nächsten Nulldurchgangs die Schleife verlassen wird,
- daraufhin die Anzahl durchlaufener Schleifenzyklen mit mindestens einem vorbestimmten Wert verglichen wird und
- je nach dem Vergleichsergebnis mindestens ein Ausgangsleiter des Prozessors in einen zugeordneten logischen Zustand gebracht wird.

2. Verfahren zum Differenzieren von Frequenzen einer Wechselspannung nach Anspruch 1, dadurch gekennzeichnet, daß
- je nach dem Vergleich mit dem ersten Ausgangsleiter die Anzahl durchlaufener Schleifenzyklen mit wenigstens einem zweiten vorbestimmten Wert verglichen wird und
- wenigstens ein zweiter Ausgangsleiter des Prozessors in einen entsprechenden logischen Zustand gebracht wird.

3. Vorrichtung zum Implementieren des Verfahrens nach Anspruch 1, wobei der mit der Versorgungswechselspannung verbundene Prozessor vorgesehen ist, der die nachfolgenden Verfahrensschritte duchführt:
- Detektieren des Nulldurchgangs der Versorgungswechselspannung in Antwort worauf in dem Prozessor das Programm mit der Schleife mit einer festen Anzahl Instruktionen gestartet wird, wobei die Zykluszeit der Schleife viel kürzer ist als die minimal vorhersehbare Periode der Wechselspannung und
- das Addieren der Anzahl durchlaufener Schleifenzyklen,
dadurch gekennzeichnet, daß der Prozessor weiterhin vorgesehen ist zum Durchführen der nachfolgenden Verfahrensschritte:
- das Detektieren des nächsten Nulldurchgangs während jedes Schleifenzyklus;
- das Unterbrechen der Schleife nach Detektiion dieses nächsten Nulldurchgangs;
- das Vergleichen der Anzahl durchlaufener Schleifenzyklen mit wenigstens einem ersten vorbestimmten Wert und
- je nach dem Ergebnis des Vergleichs, das überführen wenigstens eines ersten Ausgangsleitens in den entsprechenden logischen Zustand.

## Revendications

1. Procédé de discrimination de fréquences d'une tension alternative à l'aide d'un processeur connecté à la tension alternative, dans lequel :
- un premier passage par zéro de la tension alternative est détecté en réaction auquel un programme du processeur est initié;
- ce programme comprend une boucle avec un nombre fixe d'instructions, le temps de cycle de la boucle étant bien plus petit qu'une période minimum prévisible de la tension alternative, et
- cette boucle comprend une instruction de comptage pour compter le nombre de cycles de boucle parcourus, caractérisé en ce que:
- cette boucle comprend une instruction de détection pour détecter un passage par zéro suivant;
- en réaction à la détection de ce passage par zéro suivant, la boucle est abandonnée;
- ensuite, le nombre de cycles de boucle parcourus est comparé à au moins une première valeur prédéterminée, et
- en fonction du résultat de la comparaison, au moins un premier conducteur de sortie du processeur est déplacé vers un état logique correspondant.

2. Procédé de discrimination de fréquences d'une tension alternative selon la revendication 1, caractérisé en ce que:
- en fonction de la comparaison avec le premier conducteur de sortie, le nombre de cycles de boucle parcourus est comparé à au moins une deuxième valeur prédéterminée, et
- au moins un deuxième conducteur de sortie du processeur est déplacé vers un état logique correspondant.

3. Dispositif convenant pour mettre en oeuvre le procédé selon la revendication 1, comprenant le processeur qui est connecté à la tension alternative et prévu pour exécuter les étapes suivantes :
- détection du passage par zéro de la tension alternative en réaction à quoi le programme du processeur comprenant la boucle avec un nombre fixe d'instructions est lancé, le temps de cycle de ladite boucle étant bien plus court que la période minimum prévisible de la tension alternative, et
- addition du nombre de cycles de boucle parcourus, caractérisé en ce que le processeur est, en outre, prévu pour exécuter les étapes suivantes :
- détection du passage par zéro suivant au cours de chaque cycle de boucle;
- abandon de la boucle après détection de ce passage par zéro suivant;
- comparaison du nombre de cycles de boucle parcourus avec au moins une première valeur prédéterminée, et
- en fonction du résultat de la comparaison, déplacement d'au moins un premier conducteur de sortie vers l'état logique correspondant.
